(19) Europäisches Patentamt / European Patent Office / Office européen des brevets

(11) **EP 2 786 487 B1**

(12) **FASCICULE DE BREVET EUROPEEN**

(45) Date de publication et mention de la délivrance du brevet:
**14.06.2017 Bulletin 2017/24**

(21) Numéro de dépôt: **12795413.9**

(22) Date de dépôt: **29.11.2012**

(51) Int Cl.:
**H03K 5/01** *(2006.01)* **G01T 1/17** *(2006.01)*

(86) Numéro de dépôt international:
**PCT/EP2012/073948**

(87) Numéro de publication internationale:
**WO 2013/041733 (28.03.2013 Gazette 2013/13)**

(54) **DISPOSITIF DE RÉGULATION D'UN FLUX ALÉATOIRE D'IMPULSIONS DE TENSION EN ENTRÉE D'UN CONVERTISSEUR ANALOGIQUE-NUMÉRIQUE**

VORRICHTUNG ZUR REGELUNG EINER ZUFÄLLIGEN STRÖMUNG VON SPANNUNGSPULSEN AM EINGANG EINES ANALOG-DIGITAL-WANDLERS

DEVICE FOR REGULATING A RANDOM STREAM OF VOLTAGE PULSES AT THE INPUT OF AN ANALOG-TO-DIGITAL CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.12.2011 FR 1161116**

(43) Date de publication de la demande:
**08.10.2014 Bulletin 2014/41**

(73) Titulaire: **Commissariat à l'Énergie Atomique et aux Énergies Alternatives 75015 Paris (FR)**

(72) Inventeur: **ROSTAING, Jean-Pierre F-38260 La Côte Saint-Andre (FR)**

(74) Mandataire: **Ahner, Philippe et al BREVALEX 95, rue d'Amsterdam 75378 Paris Cedex 8 (FR)**

(56) Documents cités:
FR-A1- 2 847 676     FR-A1- 2 951 037
US-A1- 2007 029 494

**Description**

**DOMAINE TECHNIQUE**

L'invention concerne un dispositif de régulation d'un flux aléatoire d'impulsions de tension pour utilisation à l'entrée d'un convertisseur analogique-numérique, notamment pour un imageur.

**ÉTAT DE LA TECHNIQUE ANTÉRIEURE**

Un imageur est constitué d'une matrice de pixels sensibles à une gamme de rayonnements électromagnétiques. A chaque pixel est associé un détecteur photo-électrique et un circuit micro-électronique.

Un détecteur photo-électrique, lorsqu'il est soumis à un flux incident de photons d'énergie hv pour laquelle il est sensible, génère des charges électriques proportionnellement au flux incident. Le courant résultant est ensuite amplifié et traité par le circuit électronique du pixel. Le circuit électronique fournit les informations nécessaires à la reconstruction d'une image visible en mesurant l'énergie des photons reçus par le détecteur.

On doit considérer les deux principales qualités d'un imageur : sa résolution spatiale et sa résolution en énergie.

La résolution spatiale dépend de la dimension des détecteurs photo-électriques, supposés identiques pour tous les pixels, définissant la taille du point élémentaire de l'image.

La résolution en énergie dépend quant à elle de la capacité des circuits électroniques à mesurer l'énergie de l'ensemble des photons reçus par les détecteurs photo-électriques associés. On comprend en effet qu'une perte de l'énergie de certains photons reçus puisse détériorer la résolution de l'image reconstruite.

Si la résolution spatiale est aisément contrôlable, l'augmentation de la résolution en énergie se heurte aux spécifications des circuits électroniques et aux contraintes liées à ceux-ci. En effet, le circuit électronique d'un pixel est soumis à de fortes contraintes techniques : il doit principalement avoir une consommation faible et une dynamique élevée.

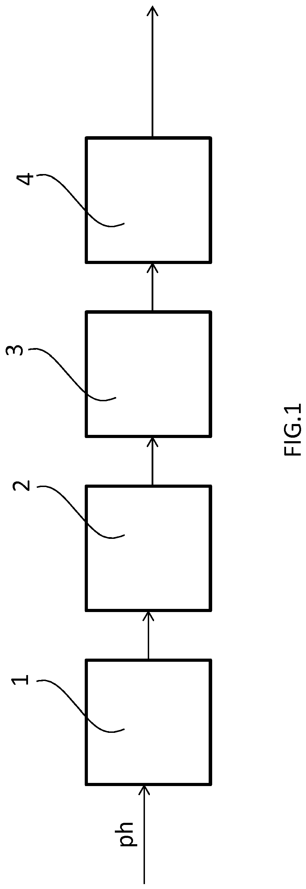

Un synoptique d'un ensemble constitué par un détecteur photo-électrique et un circuit micro-électronique associés à un pixel est illustré en figure 1. Le détecteur photo-électrique 1 reçoit des photons incidents ph et le circuit électronique se compose d'un préamplificateur de charge 2 mesurant le signal délivré par le détecteur 1, d'un dispositif d'amplification de tête 3 qui traite le signal délivré par le préamplificateur de charge 2 et d'un circuit de quantification d'énergie 4 qui numérise les signaux délivrés par le dispositif d'amplification de tête 3 afin d'obtenir l'histogramme en énergie des photons incidents. Le spectre en énergie des photons ph incidents reçus peut-être obtenu à partir de cet histogramme.

Un imageur doit être apte à mesurer finement l'énergie des photons incidents qui arrivent avec une cadence élevée. La norme actuelle est une résolution en détection de l'ordre de 1% pour un flux incident de photons de l'ordre de $10^7.s^{-1}.mm^{-2}$.

Pour ce faire, pour chaque pixel, le préamplificateur de charge 2, le dispositif d'amplification de tête 3, et le convertisseur 4 doivent avoir un rapport signal à bruit élevé afin de limiter au maximum les pertes de signal au cours du cheminement du signal, du détecteur 1 au convertisseur analogique-numérique 4.

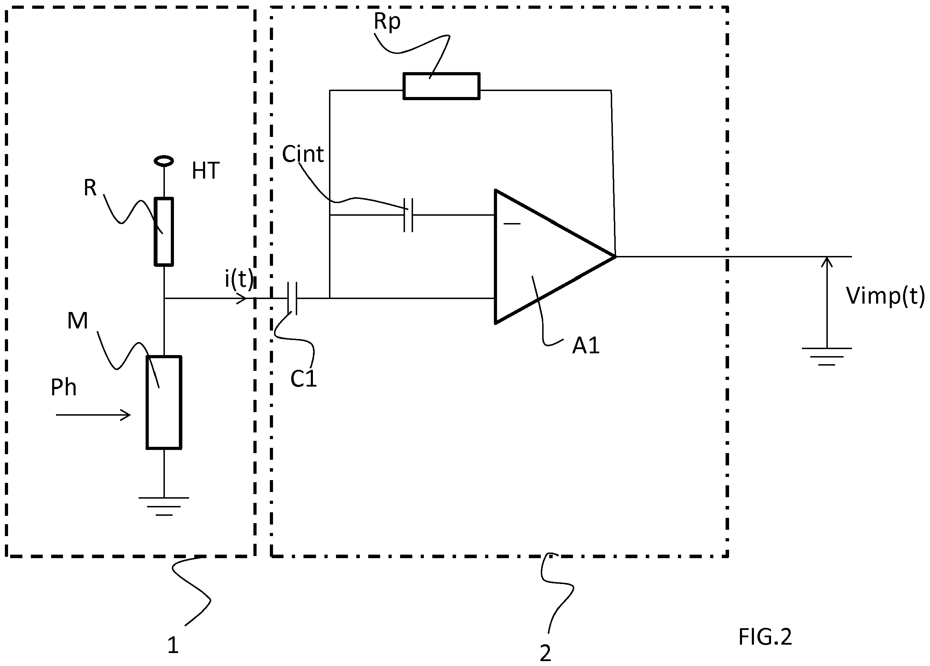

Les préamplificateurs de charge à faible bruit les plus performants sont ceux utilisant un intégrateur de courant. La figure 2 illustre un tel montage associé au détecteur 1.

Le détecteur 1 comprend un élément en un matériau M sensible au flux de photons et une résistance R qui relie l'élément M à une haute tension HT. Le circuit intégrateur de courant comprend une capacité C1, un amplificateur A1, une capacité Cint et une résistance Rp. La capacité C1 est montée sur l'entrée non-inverseuse de l'amplificateur A1 et la capacité Cint et la résistance Rp sont montées en parallèle entre l'entrée inverseuse et la sortie de l'amplificateur A1.

De manière schématique, lorsqu'un photon pénètre dans le matériau M avec une énergie suffisante, il peut interagir et créer des charges électriques dans le matériau, séparées sous l'effet du champ électrique appliqué au détecteur. L'élément M produit alors un courant de détection i(t) pendant le temps de détection du photon ph. Plus précisément, une impulsion de courant est générée pour chaque photon ph qui aura interagi dans le matériau.

Monté en sortie du détecteur 1, le préamplificateur de charge 2 reçoit le courant i(t) sous forme d'impulsions et produit en réponse la tension Vimp (t), sous forme d'impulsions, donnée par :

$$Vimp(t) = -\frac{1}{Cint}.\int i(t)dt = -Q/Cint \qquad (1)$$

où Q est la quantité de charge produite par le photon ph interagissant avec le matériau semi-conducteur.

La tension Vimp(t) délivrée par le circuit électronique 2, correspond à la tension d'entrée du dispositif d'amplification de tête 3.

Le dispositif d'amplification de tête 3, permet de mesurer l'énergie des photons détectés, c'est-à-dire l'amplitude des impulsions obtenues en sortie du circuit électronique 2. Il peut comprendre, par exemple, un filtre passe-bande en sortie du circuit électronique 2 pour optimiser le rapport signal sur bruit et un détecteur de crête en sortie du filtre passe-bande pour mesurer le maximum des impulsions de signal.

Le dispositif d'amplification de tête 3 délivre alors une impulsion de tension E(t) dont la hauteur est proportionnelle à l'impulsion produite aux bornes du détecteur 1, c'est-à-dire à l'énergie cédée par le photon ph au matériau détecteur.

Cette impulsion de tension E(t) est ensuite numérisée par le circuit de quantification 4, qui est généralement un convertisseur analogique-numérique 4. Les valeurs numériques ainsi obtenues sont fournies à un calculateur programmé pour identifier les valeurs d'énergie supérieures à un seuil d'énergie prédéterminé.

Au niveau de la sortie du dispositif d'amplification de tête 3, la fréquence d'arrivée des impulsions de tensions E(t) en entrée du convertisseur 4 est aléatoire.

Or, on sait qu'un convertisseur analogique-numérique nécessite un temps de conversion qui correspond au temps de traitement de la tension d'entrée. Plus précisément, pour chaque impulsion E(t) reçue, le convertisseur va mettre un temps $\varphi$ pour traiter la tension de l'impulsion. On dira alors que la tension de l'impulsion est traitée pendant une phase de conversion qui correspond à la période d'horloge du convertisseur. Durant la durée $\phi$ de la phase de conversion, le convertisseur est inopérant et chaque impulsion qui arrive n'est pas traitée. Dès lors, la donnée d'énergie de certains photons reçus par le détecteur 1 est perdue au niveau du circuit électronique : la résolution en détection du pixel s'en trouve par conséquent dégradée.

Afin d'estimer le taux de perte de données du fait du temps de conversion $\varphi$, on peut considérer que le nombre n d'impulsions E(t) reçues pendant un intervalle de temps t et arrivant en entrée du convertisseur 4 suit une loi de Poisson de paramètre égal à $\lambda$ ($\lambda$ étant le nombre moyen d'occurrences par intervalle de temps).

La probabilité que n impulsions soient reçues pendant le temps t est :

$$P_n(t) = e^{-\lambda t}\frac{(\lambda t)}{n!} \qquad (2)$$

$$\text{Avec } \sum_{n=0}^{\infty} P_n(t) = 1 \qquad (3)$$

La probabilité d'avoir au moins une impulsion dans un intervalle de temps t est alors:

$$\sum_{n=1}^{\infty} P_n(t) \approx 1 - P_0(t) \qquad (4)$$

Si l'on choisit un intervalle de temps $t = \frac{1}{10\lambda}$, la probabilité d'apparition des impulsions E(t) dans l'intervalle est donc :

$$1 - P_0(t) = 1 - e^{-0.1} \approx 0.095. \qquad (5)$$

En d'autres termes, presque 10% des impulsions se produisent à un rythme 10 fois supérieur à la moyenne $\lambda$.

Avec un convertisseur analogique-numérique 4 dont le temps de conversion est par exemple $Ts = \frac{1}{10\lambda}$, le taux de perte de données en sortie du convertisseur analogique-numérique 4 est de presque 10%. Cela signifie que 10% de l'information nécessaire à la reconstruction d'une image visible sont perdus.

Si l'on se place dans un cas idéal où le flux de sortie $\mu$ du convertisseur est constant, il faudrait que le convertisseur analogique-numérique 4 fonctionne à une cadence égale à environ 100 fois la valeur moyenne $\lambda$ du flux pour obtenir un taux de perte de l'ordre de 1%. Or cela consisterait à augmenter la dynamique et la vitesse de conversion du convertisseur analogique-numérique 4. Une telle augmentation des capacités du convertisseur analogique-numérique induirait un accroissement notable de sa consommation, et par là même de celle de l'électronique associée à chaque pixel. A l'échelle d'une matrice de plusieurs milliers de pixels, une telle augmentation de la consommation serait particulièrement sensible.

On est donc confronté au problème suivant : les imageurs actuels présentent un taux de perte trop important du fait de la capacité limitée de traitement du flux aléatoire d'impulsions par les convertisseurs analogiques-numériques associés aux pixels. De tels imageurs ne sont alors pas adaptés à certaines applications, notamment médicales, qui nécessitent une résolution en détection élevée.

La solution évidente qui consisterait à augmenter les capacités du convertisseur analogique-numérique n'est pas adéquate en terme de performances globales de la matrice de pixels.

Le document US 2007/0029494 A1 divulgue un système alternatif de détection photoélectrique comprenant des circuits "sample & hold" associés respectivement à un pixel, dont les sorties sont liées à la même entrée d'un convertisseur A/D. L'objectif de la présente invention est par conséquent de proposer un dispositif couplé à un convertisseur analogique-numérique qui permette de diminuer le taux de perte de données en sortie du convertisseur sans avoir à accroître les performances de ce dernier.

Un but subsidiaire de la présente invention est de proposer un imageur composé d'une matrice de pixels présentant une résolution de détection élevée.

## EXPOSÉ DE L'INVENTION

La présente invention est définie par un dispositif de conversion d'un flux aléatoire d'impulsions de tension en un flux cadencé de données numériques selon la revendication indépendante 1. Le dispositif de conversion comprend un dispositif de régulation de flux et un convertisseur analogique-numérique en sortie dudit dispositif de régulation de flux, ledit convertisseur effectuant une conversion analogique-numérique à une fréquence de conversion, ledit dispositif de régulation de flux comprenant une mémoire tampon de capacité K, K entier et K> 1, dans laquelle est stockée l'information de tension correspondant à chaque impulsion reçue, la lecture de ladite mémoire tampon étant cadencée à ladite fréquence de conversion.

Le dispositif de régulation comprend :

- une unité de détection d'amplitude qui reçoit en entrée lesdites impulsions et qui produit pour chaque impulsion reçue, un signal analogique dont l'amplitude est proportionnelle au maximum de l'amplitude de ladite impulsion, ledit signal analogique étant fourni à ladite mémoire tampon ;
- une unité de détection d'impulsions qui reçoit en entrée lesdites impulsions et qui produit en sortie un premier signal binaire qui passe à un état haut pendant le temps de détection d'une impulsion, ledit premier signal binaire étant envoyé à des moyens de contrôle pour écrire dans la mémoire tampon.

De manière préférentielle, ladite mémoire tampon de capacité K est constituée de K cellules mémoire analogiques, lesdites cellules mémoire étant mises en parallèles lorsque K> 1.

Chaque cellule mémoire comprend :

- un premier et un second commutateurs en série entre une entrée et une sortie de ladite cellule mémoire, ledit premier commutateur étant relié à la sortie de l'unité de détection d'amplitude et ledit second commutateur étant relié à l'entrée dudit convertisseur ;
- un condensateur placé entre un noeud commun aux deux commutateurs et un potentiel de référence.

La mémoire tampon comprend en outre des moyens de contrôle pour rendre passant ledit premier commutateur lorsque ledit premier signal binaire passe à un état haut et pour rendre passant ledit second commutateur lorsqu'un second signal binaire à la fréquence de conversion passe à un état haut.

L'invention concerne également un détecteur photo-électrique et un circuit électronique associés à un pixel, ledit détecteur photo-électrique étant adapté à recevoir des photons incidents et à émettre en sortie des impulsions de courant, ledit circuit électronique comportant un circuit intégrateur comprenant un premier condensateur et une première résistance placés en parallèle entre la sortie et l'entrée inverseuse d'un amplificateur opérationnel, ladite entrée inverseuse dudit amplificateur opérationnel recevant lesdites impulsions de courant, ledit circuit intégrateur émettant en sortie des impulsions de tension, ledit circuit électronique étant caractérisé en ce qu'il comporte en outre un dispositif de conversion tel que défini précedement qui reçoit en entrée la sortie dudit circuit intégrateur et qui émet en sortie un signal numérique cadencé à ladite fréquence de conversion.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

- la figure 1 illustre un synoptique d'un ensemble constitué par un détecteur photo-électrique et un circuit micro-électronique associés à un pixel, de l'état de la technique ;

- la figure 2 illustre le montage d'un préamplificateur de charge, associé à un détecteur photo-électrique, dans le pixel de la figure 1 ;
- la figure 3 illustre de manière schématique le dispositif de conversion d'un flux aléatoire d'impulsions de tension (Vimp) en un flux cadencé de données numériques selon l'invention ;
- la figure 4 représente des courbes représentatives du taux de perte du dispositif de conversion représenté en figure 3, tracées pour différents paramètres caractéristiques ;
- la figure 5 illustre un schéma du dispositif de conversion selon un mode de réalisation préféré de l'invention ;
- la figure 6 illustre un zoom de la figure 5.
- les figures 7a et 7b illustrent la configuration des moyens logiques permettant d'obtenir des indicateurs caractéristiques de la mémoire tampon du dispositif de conversion selon un mode de réalisation préféré de l'invention ;
- la figure 8 illustre un chronogramme des signaux caractéristiques en entrée et en sortie des moyens de contrôle de la mémoire tampon du dispositif de conversion selon un mode de réalisation préféré de l'invention ;
- la figure 9 illustre un synoptique d'un ensemble constitué par un détecteur photo-électrique et un circuit micro-électronique associés à un pixel, lorsque le circuit micro-électronique comprend le dispositif de conversion selon un mode de réalisation préféré de l'invention.

## EXPOSÉ DÉTAILLÉ DE MODES DE RÉALISATION PARTICULIERS

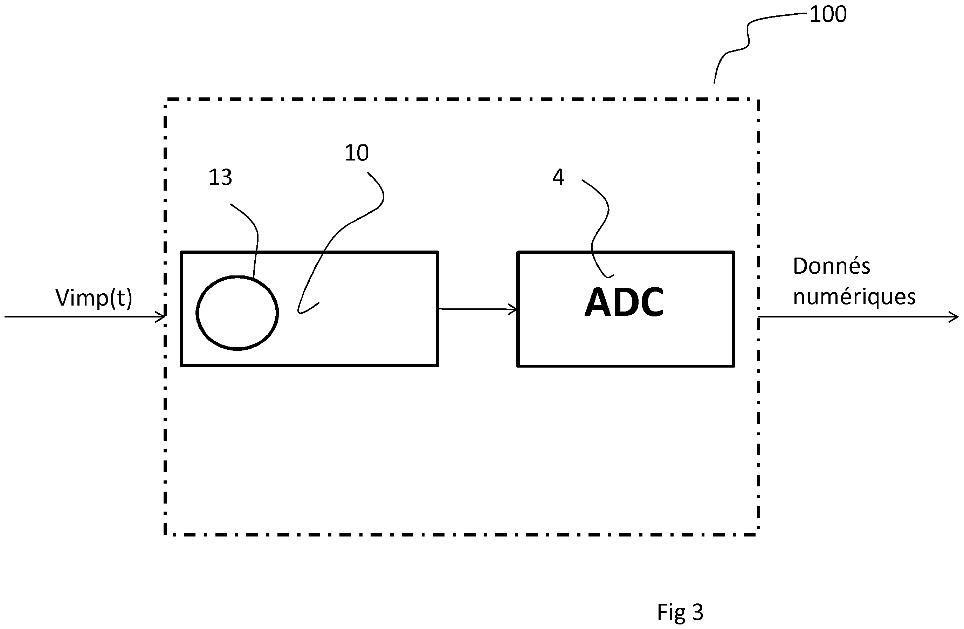

La figure 3 illustre un schéma du dispositif de conversion d'un flux aléatoire d'impulsions de tension en un flux cadencé de données numériques selon l'invention.

Plus précisément, le dispositif de conversion 100 comprend un dispositif de régulation 10 et un convertisseur analogique-numérique 4 disposé en sortie du dispositif de régulation. Le convertisseur analogique-numérique 4 a un temps de conversion $\phi$ inférieur ou égal à la période Tck de son signal d'horloge. Le dispositif de conversion 100 reçoit les impulsions de tension sous la forme du signal Vimp(t).

Le dispositif de régulation 10 comprend une mémoire tampon (ou buffer) 13 de capacité K, avec K entier supérieur ou égal à 1, dans laquelle est stockée l'information de tension de chaque impulsion reçue. Etant donné que les impulsions arrivent de manière aléatoire, on comprend que l'écriture dans la mémoire tampon intervient également de façon aléatoire.

La lecture de l'information de tension stockée dans la mémoire tampon 13 est réalisée de manière asynchrone par rapport à celle de l'écriture. En effet, la lecture de la mémoire tampon est cadencée à une fréquence identique à celle du signal d'horloge du convertisseur 4.

Ainsi, en sortie du dispositif de régulation 10, tout se passe comme si l'on avait aligné l'apparition de chaque impulsion du flux aléatoire d'impulsions avec le début d'une phase de conversion du convertisseur analogique-numérique 4. Le dispositif de régulation 10 agit donc comme une file d'attente analogique.

Afin d'illustrer les avantages procurés par l'invention, on se référera ci-après à la théorie mathématique des files d'attentes. En effet, la mémoire tampon du dispositif de régulation peut être considérée comme une file d'attente de type M/G/1/K, selon la notation de Kendall. On pourra se reporter à l'article suivant : « M/G/c/K blocking probability models and system performance », J.MacGregor Smith, Performance Evaluation 52 (2003) 237-267.

De manière non limitative, et afin de simplifier les calculs, on considèrera que le temps de conversion du convertisseur 4 est constant, et donc *a fortiori* déterministe, et que le flux d'entrée des impulsions est Poissonien.

Le dispositif de conversion 100 reçoit un flux d'entrée, noté $\lambda$, qui correspond à un nombre moyen d'arrivées d'impulsions par intervalle de temps.

Le dispositif de conversion 4 traite un ensemble de données et produit un flux de sortie, noté $\mu$, qui n'est autre que le flux de sortie du convertisseur.

Le dispositif de conversion 100 offre donc un trafic $\rho = \dfrac{\lambda}{\mu}$ correspondant au flux d'entrée pendant le temps moyen de service.

La probabilité $P_k$ de blocage est donnée par la formule suivante :

$$P_k = \frac{\rho^{(2-\sqrt{\rho}+2K)/(2-\sqrt{\rho})}\,(-1+\rho)}{\rho^{(2(2-\sqrt{\rho}+K)/(2-\sqrt{\rho}))}-1} \tag{6}$$

où K est la capacité de la mémoire tampon 13.

La probabilité de blocage Pk du dispositif de conversion correspond à la probabilité que des données ne puissent être traitées pendant le temps de conversion $\phi$. Il s'agit donc du taux de perte.

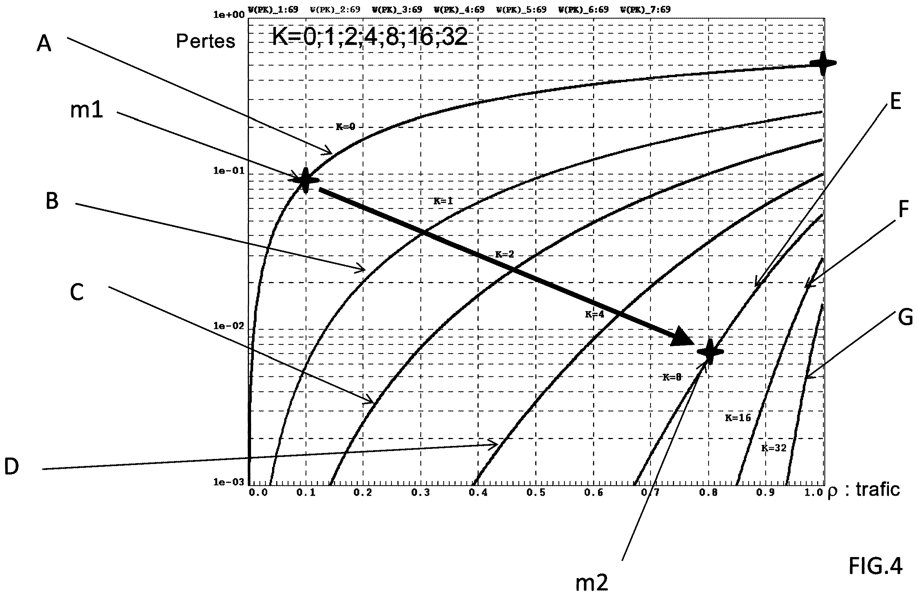

La figure 4 illustre le taux de perte $P_k$ en fonction du trafic $p$ pour différentes valeurs de K et pour une valeur de λ fixe.

La courbe A donne le taux de perte $P_k$ lorsque K=0, c'est-à-dire le taux de perte du convertisseur analogique-numérique seul.

On remarque en comparant la courbe A (K=0) et la courbe B (K=1), que la régulation effectuée par la file d'attente analogique se traduit par une diminution de l'écart-type du flux μ.

On note que l'écart type du flux μ est d'autant plus faible que la capacité K de la mémoire tampon est grande, cf. courbes C (K=2), D (K=4), E (K=8), F (K=16) et G (K=32). Une valeur de K très élevée permettrait d'obtenir une cadence de sortie approximativement égale à celle du flux d'entrée (de valeur moyenne λ), avec un taux de perte proche de zéro.

Ainsi, si l'on compare la courbe A avec la courbe E par exemple, on remarque qu'à la valeur m1 de la courbe A, $\rho = 0,1, \frac{1}{\mu} = 10\,\mathrm{ns}$ et les pertes sont de l'ordre de 10%. A la valeur m2 de la courbe E, $\rho = 0,8, \frac{1}{\mu} = 80\,\mathrm{ns}$ et les pertes sont de l'ordre de 0,7%.

Par conséquent, entre la courbe E et la courbe A, les pertes sont divisées d'un facteur 13 et μ est divisé d'un facteur 8. On en conclut qu'on peut donc diminuer les contraintes techniques et le taux de perte du convertisseur analogique-numérique en augmentant la capacité K de la mémoire tampon.

On choisira avantageusement une valeur de K suffisamment élevée pour obtenir un compromis adéquat entre la réduction souhaitée du taux de perte, les performances nécessaires du convertisseur analogique-numérique 4 et la taille de la file d'attente. On prendra K≥ 1, et de préférence $K = 2^l$ avec $l \geq 1$.

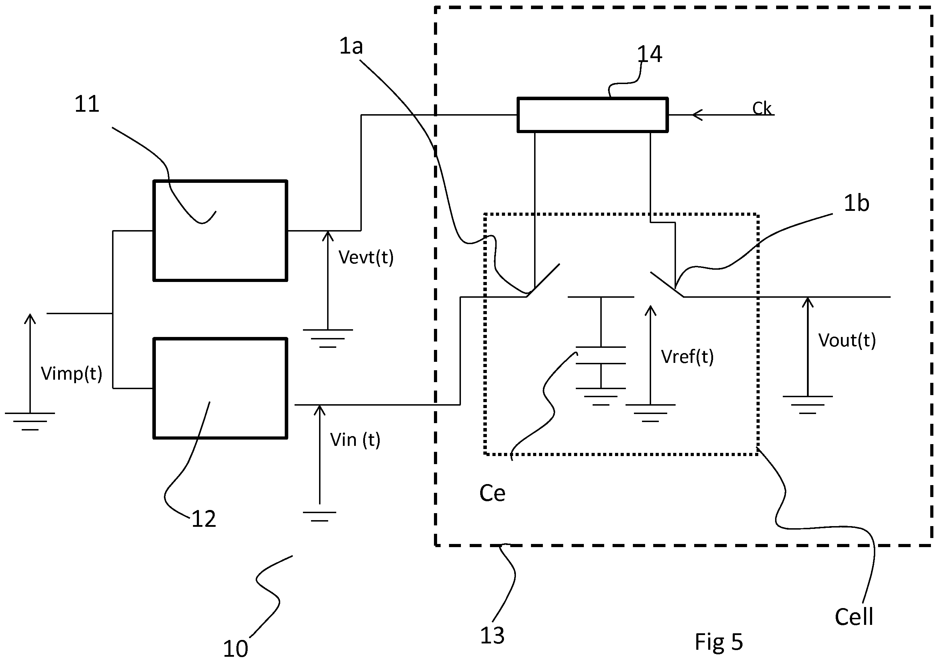

La figure 5 illustre un schéma du dispositif de conversion selon un mode de réalisation préféré de l'invention.

Plus précisément, le dispositif de régulation du flux aléatoire d'impulsions 10 selon l'invention comprend un détecteur d'impulsions 11, un détecteur de maximum d'amplitude 12 et une mémoire tampon 13.

Le détecteur d'impulsions 11 et le détecteur de maximum d'amplitude 12 reçoivent tous les deux le signal Vimp(t).

Le détecteur d'impulsions 11 fournit un signal binaire Vevt(t) qui est exploitable par un circuit numérique. Plus précisément, pour chaque impulsion de tension Vimp(t) reçue en entrée du détecteur d'impulsions 11, le signal Vevt(t) passe dans un état haut pendant la durée de l'impulsion. Lorsque le détecteur d'impulsions 11 ne détecte aucune impulsion, le signal binaire Vevt(t) en sortie du détecteur d'impulsions 11 reste dans un état bas. Le détecteur d'impulsions 11 peut être par exemple réalisé au moyen d'un circuit comparateur ou d'un circuit dérivateur, facilement réalisable par l'homme du métier.

Le détecteur de maximum d'amplitude 12 mesure l'amplitude maximum des impulsions de tension Vimp (t) qu'il reçoit. Pour chaque impulsion Vimp(t) reçue, il délivre un signal analogique Vin(t) dont la hauteur est proportionnelle à l'amplitude maximum de l'impulsion reçue. Par conséquent, le signal Vin(t) est assimilable à l'échantillonnage de la tension Vimp(t), synchrone du signal Vevt(t). Le détecteur de maximum d'amplitude 12 peut être réalisé par exemple au moyen d'un circuit détecteur de crête dont la mise en oeuvre est connue de l'homme du métier.

La mémoire tampon 13 de capacité K est constituée de K cellules mémoires Cell mises en parallèle. Sur la figure 5, on n'a représenté qu'une seule cellule mémoire. Chacune des cellules mémoire Cell comporte un premier commutateur 1a et un second commutateur 1b, en série entre l'entrée et la sortie de la cellule mémoire Cell, et un condensateur Ce placé entre le noeud commun des deux commutateurs et un premier potentiel de référence Vref(t).

Le premier commutateur 1a, ou commutateur d'écriture, est relié à la sortie du détecteur de maximum d'amplitude 12 et le second commutateur 1b, ou commutateur de lecture, est destiné à être relié à l'entrée d'un convertisseur analogique-numérique 4.

On note Vout(t) la tension en sortie de la cellule mémoire Cell.

Des moyens de contrôle 14 permettent de commander de façon asynchrone l'ouverture et la fermeture du premier commutateur 1a par rapport à l'ouverture et la fermeture du second commutateur 1b. La mise à l'état passant ou bloqué du premier commutateur 1a dépend de l'état logique haut ou bas du signal binaire Vevt(t) issu du détecteur d'impulsions 11 tandis que la mise à l'état passant ou bloqué du second commutateur dépend de l'état logique d'un signal binaire Ck issu du signal d'horloge du convertisseur, ou issu d'un signal en phase avec le signal d'horloge du convertisseur.

De manière évidente, on précise que le premier 1a et le second 1b commutateurs ne peuvent être tous les deux passants au même instant.

Lorsque le commutateur d'écriture 1a de la cellule mémoire est passant, c'est-à-dire lorsqu'une impulsion est détectée, et pendant la durée de l'impulsion détectée, la cellule mémoire Cell reçoit la tension Vin(t). L'information électrique correspondant à l'impulsion détectée est alors transférée à la capacité Ce qui se charge : les moyens de contrôle 14 écrivent dans la cellule mémoire Cell.

Lorsque le commutateur de lecture 1b de la cellule mémoire est passant, c'est-à-dire lorsque le signal d'horloge est dans un état haut et pendant une durée Tck, la capacité Ce se décharge et transmet le signal Vout(t). Ce dernier est un échantillon du signal Vimp(t) en retard sur le signal Vin(t). La cellule mémoire Cell est alors lue.

On comprendra que le flux d'impulsions qui arrivent de manière aléatoire sous la forme du signal Vimp(t) est régulé par le dispositif selon l'invention pour fournir un signal Vout(t) formé d'échantillons cadencés régulièrement.

Un avantage de la mise en parallèle de K étages, chaque étage comprenant chacun une cellule mémoire élémentaire, est d'éviter une dégradation du signal puisqu'il n'y a pas de transfert de charge entre les cellules mémoire.

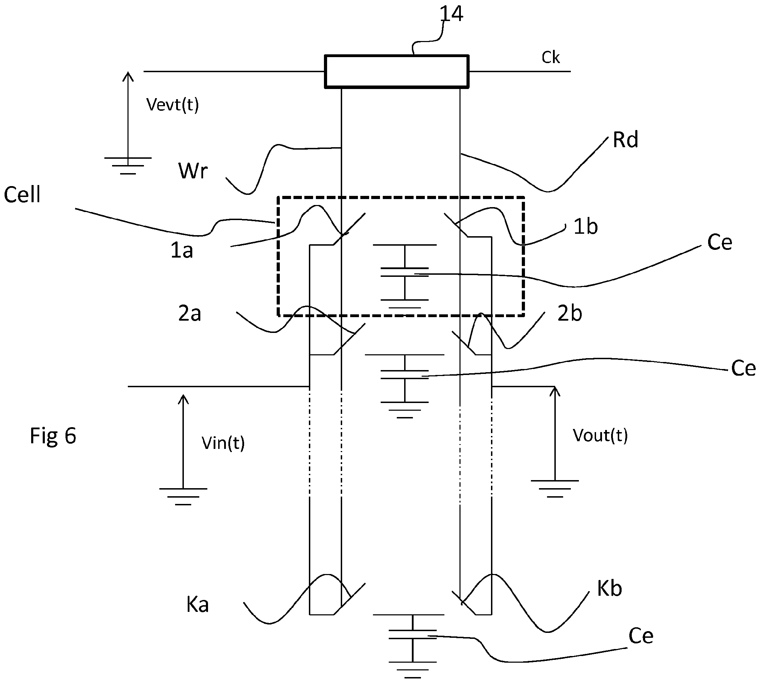

La figure 6 illustre un zoom de la mémoire tampon 13 représentée en figure 5.

Les différentes cellules mémoire de la mémoire tampon sont identiques. Ainsi, la valeur de la capacité Ce et les spécifications techniques des commutateurs d'écriture 1a,2a,...,Ka et de lecture 1b,2b,...,Kb sont les mêmes pour chacune des cellules mémoire.

Les moyens de contrôle 14 reçoivent en entrée le signal binaire Vevt(t) et le signal d'horloge Ck. En sortie, les moyens de contrôle 14 fournissent d'une part le signal d'écriture $Wr$ permettant de rendre passant les K commutateurs d'écriture et d'autre part le signal de lecture $Rd$ pour rendre passant les K commutateurs de lecture.

Les moyens de contrôle 14 agissent comme une pile FiFo (First In, First Out) pour la gestion des impulsions.

En effet, à chaque cellule mémoire k, avec k=1,...,K, est associé un indicateur binaire d'occupation $J(k)$ qui indique si la cellule mémoire est « libre » ou « occupée ». On dit qu'une cellule k, est « occupée » lorsque l'information contenue dans son condensateur Ce n'a pas été lue, c'est-à-dire qu'aucun signal de lecture $Rd(k)$ n'a été envoyé par les moyens de contrôle 14 au commutateur de lecture kb de la cellule mémoire k pour le rendre passant.

Lorsqu'une cellule mémoire k de la mémoire tampon 13 est « occupée », son indicateur binaire d'occupation $J(k)$ est égal à 1 et à 0 lorsque celle-ci est « libre ».

La lecture d'une cellule occupée entraîne la mise à 0 de l'indicateur binaire d'occupation.

Lorsqu'une impulsion est détectée par le détecteur d'impulsions 11, le signal Vevt(t) passe à un état haut le temps de l'impulsion. L'indicateur binaire d'occupation $J(k)$ de la première cellule mémoire libre k (avec k=1,...,K; K étant un nombre entier positif), de la mémoire tampon passe à 1: la cellule mémoire k est donc occupée. Les moyens de contrôle 14 envoient dans le même temps un signal d'écriture Wr(k) au commutateur d'écriture ka de la cellule mémoire k pour le rendre passant afin d'écrire dans celle-ci.

L'écriture est alors faite sur la capacité Ce de la cellule mémoire k pendant la durée $\theta$ de l'impulsion durant laquelle le commutateur d'écriture ka est passant. Les commutateurs d'écriture des autres cellules mémoires étant alors ouverts durant la durée $\theta$.

Chaque information électrique relative ne peut être inscrite que dans une seule cellule mémoire puisque deux commutateurs d'écriture 1a,2a,...,Ka ne peuvent être passants au même moment.

La commande des commutateurs de lecture est périodique et est effectuée par un générateur de K phases non recouvrantes.

Avantageusement, K sera un multiple de 2, de préférence une puissance de 2, afin de faciliter la mise en place d'une logique binaire au niveau des moyens de contrôle 14. Dans la suite de la description, on considérera que K est une puissance de 2.

Plus précisément, le générateur se compose d'un compteur binaire modulo K cadencé par un signal d'horloge de période Tck qui délivre un mot binaire de N bits de valeur $2^N$.

Le compteur est avantageusement synchrone puisque le dispositif selon l'invention est destiné à un fonctionnement à fréquence élevée.

De préférence, l'horloge de période Tck est l'horloge du convertisseur. Dans la suite de la description, on considérera que le signal d'horloge provient du convertisseur analogique-numérique.

En sortie du compteur, un décodeur N vers K convertit le mot binaire $2^N$ en K phases $phi(1), ..., phi(K)$ de durée Tck. Chaque phase correspond à une phase de lecture propre à une cellule mémoire. La durée Tck correspond donc au temps durant lequel un commutateur de lecture 1b,2b,...,Kb d'une cellule mémoire est passant pendant la lecture de la cellule.

Enfin, des bascules de type RS assurent le non recouvrement des K phases $phi(1), ..., phi(K)$ pour empêcher la conduction simultanée de deux commutateurs de lecture 1b,2b,...,Kb.

Les phases $phi(1), ..., phi(K)$ et les indicateurs binaires d'occupation $J(1), ...,J(K)$ des cellules sont les entrées d'une porte logique ET dont la sortie est un signal de lecture $Rd(1),...,Rd(K)$. Pour la cellule mémoire k, le signal de lecture $Rd(k)$ est donc défini par $(k) = phi(k).J(k)$.

Ainsi, dans le cas la cellule mémoire k est lue pendant la phase de lecture $phi(k)$ correspondante, on a: $Rd(k) = phi(k). J(k)=1.J(k)$.

Par conséquent, dans le cas où la cellule k est « occupée », $Rd(k) = 1$.

Ainsi, la lecture est faite avec la décharge de la capacité Ce de la cellule mémoire k pendant une période Tck durant laquelle les moyens de contrôle 14 envoient un signal de lecture $Rd(k)$ au commutateur de lecture kb pour le rendre passant, les autres commutateurs d'écriture étant ouverts.

Lors de la phase de lecture suivante,$phi(k + 1)$, l'indicateur binaire d'occupation $J(k)$ de la cellule k est mis à 0. La cellule k est donc libre.

En revanche, dans le cas où la cellule k est libre : $Rd(k) = phi(k).J(k)= 1.J(k)=0$. Ainsi, aucun signal de lecture n'est envoyé au commutateur de lecture kb.

Puisque pour une même cellule, les commutateurs d'écriture 1a,2a,...,Ka et de lecture 1b,2b,...,Kb ne peuvent être passants en même temps, on comprend bien que la lecture est décalée de l'écriture pour une même cellule. La durée d'écriture $\theta$ est petite devant la durée de lecture Tck. Le taux de remplissage de la capacité mémoire de valeur C par le circuit amont de résistance de sortie R est égal à 1-exp(-$t$/$RC$). Typiquement, une durée d'écriture $t$ = $5RC$ assure une charge supérieure à 99%. Par exemple avec C=0.2 pF et R=1 k$\Omega$ on obtient t = 1ns.

De manière préférentielle, les moyens de contrôle 14 sont configurés pour initier l'écriture dans une cellule prédéterminée, dès que cette cellule est libre. Dans la suite de la description, on considérera que cette cellule est la première cellule 1.

Pour ce faire, les moyens de contrôle 14 comportent avantageusement des moyens pour initier l'écriture dans la première cellule.

Ainsi des indicateurs *AJ* et *JM*1 peuvent être créés grâce à la mise en oeuvre de moyens logiques.

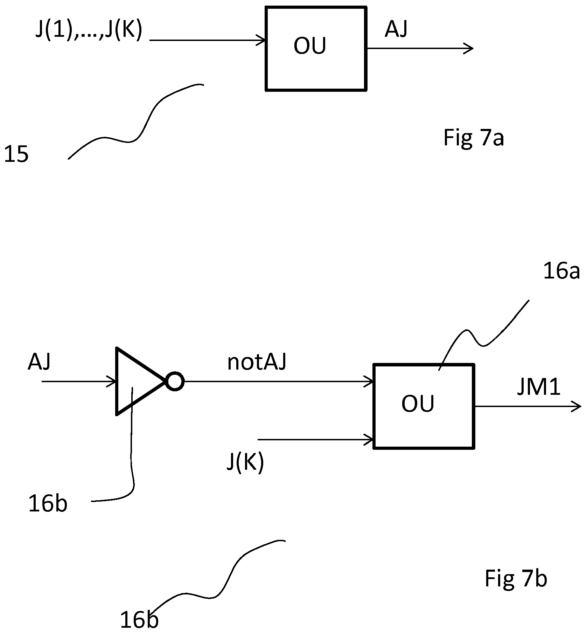

Les figures 7a et 7b illustrent les moyens logiques 15,16 respectifs permettant d'obtenir les indicateurs *AJ* et *JM*1.

L'indicateur *AJ* est fourni par une porte logique 15 OU recevant en entrée les indicateurs binaires d'occupation des K cellules mémoire.

Lorsque *AJ*=0, aucune cellule mémoire ne contient d'information. Toutes les cellules sont libres. En revanche, lorsque *AJ* = 1, la mémoire tampon comporte une ou plusieurs cellules à lire.

L'indicateur *JM*1 est fourni par une porte logique 16 qui est composée d'une porte logique OU 16a et d'une porte logique inverseuse 16b. La porte logique OU 16a reçoit en entrée l'indicateur binaire d'occupation de la dernière cellule *J(K)* et le signal inverse de *AJ,* noté *notAJ.* Le signal *notAJ* est fourni par la porte logique inverseuse 16b qui reçoit en entrée le signal *AJ.*

Lorsque toutes les cellules de la mémoire tampon sont libres (*notAJ* = 1), ou lorsque la dernière cellule K est occupée *J(K)*=1*,* alors l'indicateur *JM*1 =1. Dans ce cas, les moyens de contrôle 14 écrivent en priorité l'information électrique correspondant à la prochaine impulsion détectée dans la première cellule mémoire.

Les moyens de contrôle 14 peuvent comporter d'autres indicateurs permettant de suivre le fonctionnement et la charge de travail de la mémoire tampon 13. Ainsi, d'autres indicateurs peuvent être mis en place afin de mesurer le taux d'occupation de la mémoire tampon 13.

Avantageusement, un moyen de remise à zéro des moyens de contrôle 14 peut être mis en place. Ce moyen de remise à zéro, lorsqu'il est activé peut alors transmettre un signal de remise à zéro aux moyens de contrôle 14 afin de les initialiser (RESET).

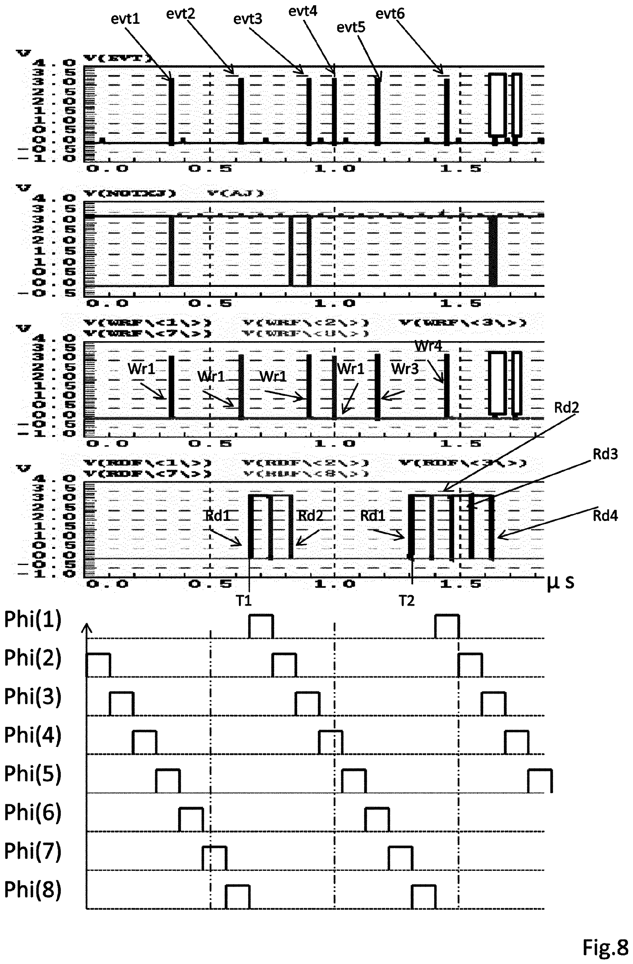

La figure 8 représente un chronogramme de simulation des signaux caractéristiques des moyens de contrôle 14 pour une mémoire tampon de capacité égale à huit. La valeur K=8 est un bon compromis entre les performances du dispositif de régulation 10 et le nombre de cellules mémoire Cell utilisées. Une valeur de K inférieure ou supérieure à 8 peut bien évidement être choisie et les explications données ici à titre d'exemple pour K=8 restent valables.

Les signaux caractéristiques sont d'une part le signal Vevt(t) et les phases de lectures *phi* (1), *..., phi*(8) et d'autre part les signaux de sortie des moyens de contrôle 14 qui sont le signal relatif à l'indicateur *AJ* ainsi que les signaux d'écriture *Wr*(1),...*Wr*(8) et les signaux de lecture *Rd*(1),...*Rd*(8)

Avant l'arrivée des impulsions, le dispositif est remis à zéro grâce à la commande de remise à zéro des moyens de contrôle 14. Il est donc dans un état initial dans lequel toutes les cellules mémoire sont libres.

L'indicateur *AJ* est à zéro avant l'arrivée du premier évènement, evt1 : *AJ* = 0 et donc *JM* = 1. Les moyens de contrôle 14 écrivent donc dans la cellule mémoire 1.

A la détection de la première impulsion, le signal Vevt(t) passe dans un état haut, représenté par le pic evt1 sur la figure 8. L'indicateur binaire d'occupation passe à 1, *J*(1) = 1, et un signal d'écriture *Wr*(1) correspondant est envoyé par les moyens de contrôle 14 au commutateur 1a pour le rendre passant pendant la durée de la première impulsion.

Tant que la cellule 1 est occupée, c'est-à-dire qu'elle n'est pas lue, les moyens de contrôle 14 génèreront pour l'impulsion détectée suivante, un indicateur binaire d'occupation pour la cellule mémoire libre 2. Dans notre exemple, à la détection de la seconde impulsion, le signal Vevt(t) repasse dans un état haut, représenté par le pic evt2 : les moyens de contrôle 14 créent un indicateur binaire d'occupation *J*(2) = 1 et envoient un signal d'écriture *Wr(2)* au commutateur d'écriture 2a de la cellule 2 pour le rendre passant.

Pour ces deux impulsions détectées, pics evt1 et evt2, seuls deux indicateurs binaires d'occupation sont créés. Les autres indicateurs binaires d'occupation sont donc nuls. Par conséquent, aucun signal d'écriture correspondant n'est envoyé aux cellules 3,4,5,6,7,8.

Dans notre exemple, la période Tck est de 80 ns. La lecture est donc cadencée régulièrement avec une période de 80 ns.

Lors du pic evt1, la phase de lecture est celle de la cellule 5 comme le montre la courbe indicative de l'état de la phase *phi*(5). Le signal de lecture est donc *Rd*(5) = *phi*(5).*J*(5) = 0 puisque la cellule mémoire 5 est libre. Il n'y a donc aucun signal envoyé au commutateur de lecture de la cellule 5. De manière similaire, les signaux *Rd*(6),*Rd*(7),*Rd*(8) sont nuls.

Au temps T1, postérieur au temps de réception de la seconde impulsion, evt2, la phase de lecture est celle de la cellule 1 comme le montre la courbe indicative de l'état de la phase $phi(1)$. Dans ce cas $Rd(1) = Phi(1).J(1) = 1$. Un signal de lecture est donc envoyé au commutateur de lecture 1b de la première cellule mémoire et la cellule mémoire 1 est « lue ».

A la phase de lecture suivante, c'est-à-dire $Phi(2)$, on a alors $Rd(2) = 1$ et l'indicateur binaire d'occupation $J(1)$ de la cellule 1 est mis à 0. De même, lors de la phase de lecture $Phi(3)$, l'indicateur binaire d'occupation $J(2)$ de la cellule mémoire 2 est mis à 0.

Lors de la détection de la troisième impulsion, le signal Vevt(t) passe dans un état haut, représenté par le pic evt3. A cet instant, toutes les cellules sont libres. L'indicateur $AJ$ est donc nul comme le montre la courbe représentative du signal $AJ$. Par conséquent l'indicateur $JM1$ est égal à 1. Les moyens de contrôle 14 vont donc « écrire » l'information électrique correspondant à la prochaine impulsion dans la cellule mémoire 1.

Dès lors, en réponse au pic evt 3, les moyens de contrôle 14 génèrent un indicateur binaire d'occupation $J(1)$ = 1 et envoient un signal d'écriture $Wr(1)$ à la cellule 1 pour rendre le commutateur 1a passant. Les impulsions correspondant aux pics evt4, evt5, evt6, sont respectivement écrites dans les cellules mémoires 2, 3, 4.

Ainsi, à la détection de la quatrième impulsion, pic evt4, un indicateur binaire d'occupation $J(2) = 1$ est généré et un signal d'écriture $Wr(2)$ correspondant est envoyé à la cellule 2 à la détection de la cinquième impulsion, pic evt5, un indicateur binaire d'occupation $J(3) = 1$ est créé et un signal d'écriture $Wr(5)$ correspondant est envoyé à la cellule 3, et à la détection de la sixième impulsion, pic evt6, un indicateur binaire d'occupation $J(4) = 1$ est généré et un signal d'écriture $Wr(4)$ correspondant est envoyé à la cellule 4.

Pour ces impulsions, seuls 4 indicateurs binaires d'occupation sont créés. Les autres indicateurs binaires d'occupation $J(5),...,J(8)$ sont donc nuls. Aucun signal d'écriture correspondant n'est envoyé aux cellules 5, 6, 7, 8.

A l'instant de la réception de la troisième impulsion, pic evt3, la phase de lecture est celle de la cellule mémoire 3 comme le montre la courbe indicative de l'état logique de la phase $phi(3)$. Le signal de lecture est donc $Rd(3) = 0$ puisque la cellule mémoire 3 est libre à cet instant. De manière similaire, les signaux $Rd(4),Rd(5),Rd(6),Rd(7),Rd(8)$ sont nuls.

Au retour du cycle de lecture à la cellule 1 c'est-à-dire au temps T2, on a $Rd(1) = Phi(1).J(1) = 1$. Un signal de lecture est donc envoyé au commutateur de lecture de la première cellule. A la phase de lecture suivante, c'est-à-dire $Phi(2)$, on a $Rd(2) = 1$ et l'indicateur binaire d'occupation de la cellule 1 est mis à 0. De même, lors de la phase de lecture $Phi(3)$, on a $Rd(3) = 1$ et l'indicateur binaire d'occupation de la cellule 2 est mis à 0, et lors de la phase de lecture $Phi(4)$, on a $Rd(4) = 1$ et l'indicateur binaire d'occupation de la cellule 3 est mis à 0.

L'indicateur binaire d'occupation de la cellule 4 est remis à zéro lors de la phase de lecture $Phi(5)$.

Une fois la phase de lecture $Phi(4)$ finie, $AJ=0$. Par conséquent, à la réception de l'impulsion suivante, les moyens de contrôle 14 écriront en priorité dans la cellule 1.

L'indicateur $JM1$ est utilisé dans le cas où la cellule 8 est occupée, c'est-à-dire $J(8) = 1$. Dans ce cas, l'indicateur $JM1$ est égal à 1 et les moyens de contrôle 14 écrivent l'information électrique correspondant à l'impulsion suivante sur la cellule 1 en priorité.

Le dispositif de conversion 100 tel qu'illustré en figure 5 peut être réalisé en électronique discrète avec des composants du commerce.

Le dispositif de régulation selon l'invention est intégrable, est adapté à une intégration micro-électronique en technologie CMOS. Une telle réalisation présente l'avantage d'être peu coûteuse et permet d'obtenir des performances remarquables, notamment en termes de consommation électrique.

Les commutateurs sont de préférence des transistors MOSFET et dans ce cas, l'augmentation de la valeur de capacité Ce permet de diminuer le bruit de recharge (dit bruit kT/C).

De manière préférentielle, on choisira une implantation en technologie courante CMOS $0,13\mu m$. Le dispositif peut-être réalisé sous forme d'un circuit spécifique ou ASIC (acronyme de l'anglais : « Application Specific Integrated Circuit »).

Le dispositif de régulation répond aux contraintes suivantes :

- faible sensibilité aux variations technologiques afin de limiter les dispersions d'un circuit à l'autre ;
- faible sensibilité aux variations environnementales ;
- bruit faible ;
- dynamique élevée ;
- faible consommation.

L'encombrement évalué du dispositif de régulation 10 dans une technologie CMOS $0,13\mu m$ est de $800\mu m^2$. Lorsque l'on compare cet encombrement à celui d'un convertisseur analogique-numérique 8bits 12,5MHz réalisé dans la même technologie, estimé à $200 \times 400\mu m^2 = 80000\mu m^2$, on remarque que le dispositif de régulation 10 proposé occupe 1% de la surface du convertisseur et permet d'en diviser la contrainte « produit (vitesse x pertes) » par 100 dans le cas où K=8.

Le dispositif de conversion 100 décrit ci-avant peut-être intégré dans le circuit électronique associé à un pixel.

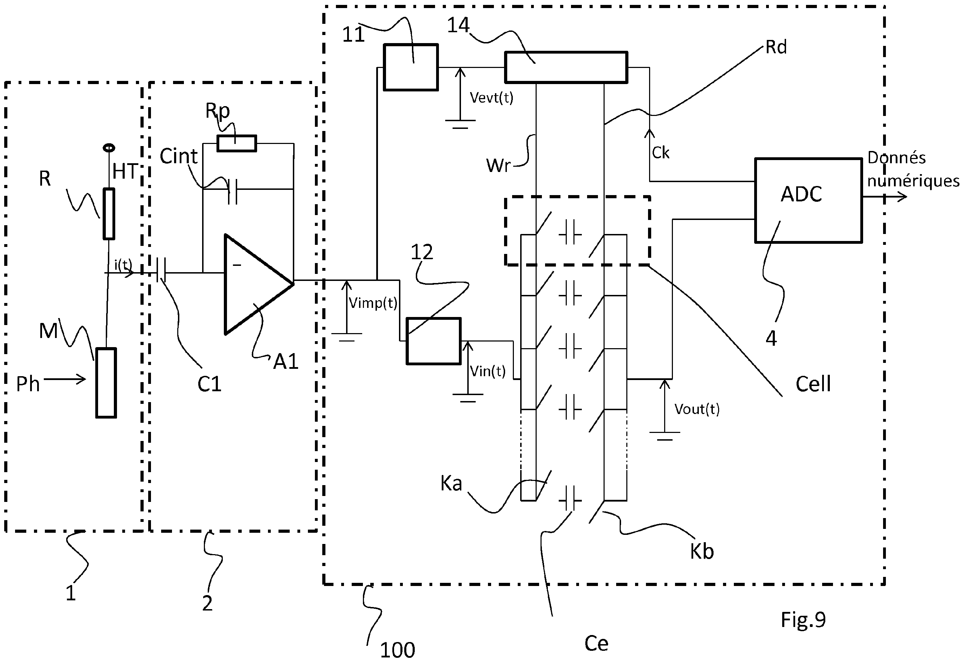

Plus précisément, la figure 9 illustre un synoptique d'un détecteur photo-électrique et d'un circuit électronique associés à un pixel, lorsque le circuit électronique comprend le dispositif de conversion 100 réalisé selon le mode de réalisation préféré de l'invention.

Le détecteur 1 est tel que décrit précédemment en relation avec la figure 2. Le détecteur 1 comprend avantageusement un élément photo-électrique en matériau semi-conducteur M, comme le CdZnTe, ou CdTe:Cl, ou encore CdTe :In, et une résistance R le reliant à une haute tension HT. La sortie du détecteur est reliée à un préamplificateur de charge 2 fournissant une tension Vimp(t) en réponse aux impulsions de courant i(t) délivrées par le détecteur.

Un dispositif de conversion 100 selon l'invention est disposé en sortie du préamplificateur de charge 2. Il reçoit en entrée la tension Vimp(t). Un signal d'horloge Ck issu du convertisseur 4 est envoyé aux moyens de contrôle 14 du dispositif 100 de régulation d'une succession aléatoire d'impulsions de tension afin de contrôler le ou les commutateurs de lecture du dispositif grâce au signal de lecture *Rd*.

L'implantation du dispositif de conversion 100 dans le circuit micro-électronique associé au pixel permet d'augmenter la résolution en détection d'un imageur comprenant une matrice de pixels tout en utilisant des convertisseurs analogiques-numériques moins rapides.

Un tel imageur trouvera application lorsque le flux est aléatoire. Il peut notamment être utilisé dans le domaine médical.

## Revendications

1. Dispositif de conversion (100) d'un flux aléatoire d'impulsions de tension (Vimp) en un flux cadencé de données numériques comprenant, un dispositif de régulation de flux (10) et un convertisseur analogique-numérique (4) en sortie dudit dispositif de régulation de flux (10), ledit convertisseur effectuant une conversion analogique-numérique à une fréquence de conversion, ledit dispositif de régulation de flux (10) comprenant une mémoire tampon (13) constituée de K cellules mémoire analogiques comprenant chacune un condensateur et montées en parallèle, K entier et K> 1, dans laquelle est stockée, dans une phase d'écriture, l'information de tension correspondant à chaque impulsion reçue, la lecture des cellules de ladite mémoire tampon étant cadencée à ladite fréquence de conversion et réalisée de manière asynchrone par rapport à l'écriture, un indicateur binaire d'occupation étant associé à chaque cellule mémoire, ledit indicateur d'occupation indiquant que la cellule est occupée lorsque l'information de tension stockée dans la cellule n'a pas été lue et indiquant que la cellule est libre dans le cas inverse, l'écriture de l'information de tension étant effectuée dans la première cellule mémoire libre de la mémoire tampon, aucune lecture d'une cellule mémoire n'étant réalisée lorsque cette cellule mémoire est indiquée comme libre.

2. Dispositif (100) selon la revendication 1 **caractérisé en ce que** le dispositif de régulation (10) comprend :

   - une unité de détection d'amplitude (12) qui reçoit en entrée lesdites impulsions (Vimp) et qui produit pour chaque impulsion reçue, un signal analogique (Vin) dont l'amplitude est proportionnelle au maximum de l'amplitude de ladite impulsion, ledit signal analogique (Vin) étant fourni à ladite mémoire tampon (13) ;
   - une unité de détection d'impulsions (11) qui reçoit en entrée lesdites impulsions (Vimp) et qui produit en sortie un premier signal binaire (Vevt) qui passe à un état haut pendant le temps de détection d'une impulsion, ledit premier signal binaire (Vevt) étant envoyé à des moyens de contrôle (14) pour écrire dans la mémoire tampon (13).

3. Dispositif (100) selon la revendication 2, **caractérisé en ce que** chaque cellule mémoire comprend :

   • un premier (1a) et un second commutateurs (1b) en série entre une entrée et une sortie de ladite cellule mémoire (Cell), ledit premier commutateur étant relié à la sortie de l'unité de détection d'amplitude (12) et ledit second commutateur étant relié à l'entrée dudit convertisseur (4) ;
   • ledit condensateur (Ce) est placé entre un noeud commun aux deux commutateurs et un potentiel de référence (Vref).

4. Dispositif (100) selon la revendication 3, **caractérisé en ce que** ladite mémoire tampon (13) comprend en outre des moyens de contrôle (14) pour rendre passant ledit premier commutateur (1a,2a,..., Ka) lorsque ledit premier signal binaire (Vevt) passe à un état haut et pour rendre passant ledit second commutateur (1b,2b,..., Kb) lorsqu'un second signal binaire (Ck) à la fréquence de conversion passe à un état haut.

**5.** Détecteur photo-électrique et circuit électronique associés à un pixel, ledit détecteur photo-électrique étant adapté à recevoir des photons incidents (ph) et à émettre en sortie des impulsions de courant (i), ledit circuit électronique comportant un circuit intégrateur (2) comprenant un premier condensateur (Cint) et une première résistance (Rp) placés en parallèle entre la sortie et l'entrée inverseuse d'un amplificateur opérationnel (A1), ladite entrée inverseuse dudit amplificateur opérationnel (A1) recevant lesdites impulsions de courant(i), ledit circuit intégrateur émettant en sortie des impulsions de tension (Vimp), ledit circuit électronique étant **caractérisé en ce qu'**il comporte en outre un dispositif de conversion (100) selon l'une quelconque des revendications précédentes qui reçoit en entrée la sortie (Vimp) dudit circuit intégrateur (2) et qui émet en sortie un signal numérique cadencé à ladite fréquence de conversion.

**Patentansprüche**

**1.** Vorrichtung (100) zur Umwandlung eines zufälligen Stroms von Spannungspulsen (Vimp) in einen getakteten Strom von digitalen Daten, umfassend eine Vorrichtung zur Regelung des Stroms (10) und einen Analog-Digital-Wandler (4) am Ausgang der Vorrichtung zur Regelung des Stroms (10), wobei der Wandler eine Analog-Digital-Umwandlung mit einer Umwandlungsfrequenz durchführt, wobei die Vorrichtung (10) zur Regelung des Stroms einen Zwischenspeicher (13) umfasst, der mit K analogen Speicherzellen gebildet ist, die jeweils einen Kondensator umfassen und parallel montiert sind, wobei K eine ganze Zahl und K>1 ist, in dem in einer Schreibphase die Spannungsinformation entsprechend jedem empfangenen Puls gespeichert wird, wobei das Auslesen der Zellen des Zwischenspeichers mit der Umwandlungsfrequenz getaktet ist und bezüglich des Schreibens auf asynchrone Weise realisiert wird, wobei jeder Speicherzelle ein binärer Besetzungsindikator zugeordnet ist, wobei der Besetzungsindikator anzeigt, dass die Zelle besetzt ist, wenn die in der Zelle gespeicherte Spannungsinformation nicht ausgelesen worden ist, und im entgegengesetzten Fall anzeigt, dass die Zelle frei ist, wobei das Schreiben der Spannungsinformation in der ersten freien Speicherzelle des Zwischenspeichers durchgeführt wird, wobei kein Auslesen einer Speicherzelle erfolgt, wenn diese Speicherzelle als frei angezeigt wird.

**2.** Vorrichtung (100) nach Anspruch 1, **dadurch gekennzeichnet, dass** die Regelungsvorrichtung (10) umfasst:

- eine Amplitudenerfassungseinheit (12), die am Eingang die Pulse (Vimp) empfängt, und die für jeden empfangenen Puls ein analoges Signal (Vin) erzeugt, dessen Amplitude proportional ist zum Maximum der Amplitude des Pulses, wobei das analoge Signal (Vin) an den Zwischenspeicher (13) geliefert wird;
- eine Pulserfassungseinheit (11), die am Eingang die Pulse (Vimp) empfängt, und die am Ausgang ein erstes binäres Signal (Vevt) erzeugt, das während der Erfassungszeit eines Pulses in einen Hoch-Zustand übergeht, wobei das erste binäre Signal (Vevt) an Steuerungsmittel (14) zum Schreiben in den Zwischenspeicher (13) geschickt wird.

**3.** Vorrichtung (100) nach Anspruch 2, **dadurch gekennzeichnet, dass** jede Speicherzelle umfasst:

• einen ersten (1a) und einen zweiten (1b) Schalter in Reihe zwischen einem Eingang und einem Ausgang der Speicherzelle (Cell), wobei der erste Schalter mit dem Ausgang der Amplitudenerfassungseinheit (12) verbunden ist, und der zweite Schalter mit dem Eingang des Wandlers (4) verbunden ist;
• wobei der Kondensator (Ce) zwischen einem Knoten, der den beiden Schaltern gemeinsam ist, und einem Referenzpotential (Vref) platziert ist.

**4.** Vorrichtung (100) nach Anspruch 3, **dadurch gekennzeichnet, dass** der Zwischenspeicher (13) ferner Steuermittel (14) umfasst, um den ersten Schalter (1a, 2a,..., Ka) durchlässig zu machen, wenn das erste binäre Signal (Vevt) in einen Hoch-Zustand übergeht, und um den zweiten Schalter (1b, 2b,..., Kb) durchlässig zu machen, wenn ein zweites binäres Signal (Ck) mit der Umwandlungsfrequenz in einen Hoch-Zustand übergeht.

**5.** Fotoelektrischer Detektor und elektronische Schaltung, die einem Pixel zugeordnet sind, wobei der fotoelektrische Detektor dazu ausgelegt ist, einfallende Photonen (ph) zu empfangen und am Ausgang Strompulse (i) auszugeben, wobei die elektronische Schaltung eine Integratorschaltung (2) umfasst, die einen ersten Kondensator (Cint) und einen ersten Widerstand (Rp) umfasst, die parallel zwischen dem Ausgang und dem invertierenden Eingang eines Operationsverstärkers (A1) platziert sind, wobei der invertierende Eingang des Operationsverstärkers (A1) die Strompulse (i) empfängt, wobei die Integratorschaltung am Ausgang Spannungspulse (Vimp) ausgibt, wobei die elektronische Schaltung **dadurch gekennzeichnet ist, dass** sie ferner eine Umwandlungsvorrichtung (100) nach einem der vorhergehenden Ansprüche umfasst, die am Eingang die Ausgabe (Vimp) der Integratorschaltung (2) empfängt, und die am Ausgang ein digitales Signal ausgibt, das mit der Umwandlungsfrequenz getaktet ist.

**Claims**

1. A device (100) for converting a random stream of voltage pulses (Vimp) into a regulated stream of digital data, comprising a stream regulation device (10) and an analog-digital converter (4) at the output of the said stream regulation device (10), where the said converter performs an analog-digital conversion at a conversion frequency, where the said stream regulation device (10) includes a buffer memory (13) consisting of K analog memory cells mounted in parallel each comprising a condensator where K is an integer and K≥ 1, in which the voltage signal for each received pulse is stored, in a write phase, and where reading of the said buffer memory is regulated at the said conversion frequency and performed in an asynchronous manner relative to the writing, a binary occupation indicator being associated with each and every memory cell, said occupation indicator indicating that the cell is occupied when the voltage signal stored in the cell has not been read and indicating that the cell is free otherwise, the writing of the voltage signal being performed in the first free memory cell of the buffer memory, and no reading of a cell memory being performed when this cell is free.

2. device (10) includes:

   - an amplitude detection unit (12) which receives the said pulses (Vimp) at input, and which produces for each pulse received an analog signal (Vin) the amplitude of which is proportional to the maximum amplitude of the said pulse, and where the said analog signal (Vin) is supplied to the said buffer memory (13);
   - a pulse detection unit (11) which receives the said pulses (Vimp) at input, and which produces at output a first binary signal (Vevt) which changes to a high level over the pulse detection time, where the said first binary signal (Vevt) is sent to control means (14) in order to write in the buffer memory (13).

3. A device (100) according to claim 2, **characterised in that** each memory cell includes:

   • a first switch (1a) and a second switch (1b) in series between an input and an output of the said memory cell (Cell), where the said first switch is connected to the output of the amplitude detection unit (12), and the said second switch is connected to the input of the said converter (4);
   • the said condensator (Ce) is positioned between a node common to both switches and a reference potential (Vref).

4. A device (100) according to claim 3, **characterised in that** the said buffer memory (13) also includes control means (14) to change the said first switch (1a, 2a, ..., Ka) to the on state when the said first binary signal (Vevt) changes to a high level, and to change the said second switch (1b, 2b, ..., Kb) to the on state when a second binary signal (Ck) at the conversion frequency changes to a high level.

5. A photoelectric detector and an electronic circuit associated with a pixel, where the said photoelectric detector is able to receive incident photons (ph), and to emit current pulses (i) at output, where the said electronic circuit includes an integrated circuit (2) including a first condensator (Cint) and a first resistor (Rp), placed in parallel between the output and the inverter input of an operational amplifier (A1), where the said inverter input of the said operational amplifier (A1) receives the said current pulses (i), where the said integrator circuit emits voltage pulses (Vimp) at output, where the said electronic circuit is **characterised in that** it also includes a conversion device (100) according to any one of the previous claims, which receives at input the output (Vimp) of the said integrator circuit (2), and which emits at output a regulated digital signal at the said conversion frequency.

FIG.1

FIG.2

Fig 3

FIG.4

Fig 5

EP 2 786 487 B1

Fig 6

EP 2 786 487 B1

Fig 7a

J(1),...,J(K) → OU → AJ

15

Fig 7b

16a

J(K), AJ, notAJ → OU → JM1

16b

Fig.8

Fig.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   US 20070029494 A1

**Littérature non-brevet citée dans la description**

*   **J.MACGREGOR SMITH.** M/G/c/K blocking probability models and system performance. *Performance Evaluation,* 2003, vol. 52, 237-267